# EUROPEAN PATENT APPLICATION

(11) **EP 2 833 402 A1**
(43) Date of publication of application: **04.02.2015**
(21) Application number: 13767597.1
(22) Date of filing: 29.03.2013
(51) Int. Cl.: H01L 23/473

(54) **FLOW PATH MEMBER, AND HEAT EXCHANGER AND SEMICONDUCTOR DEVICE USING SAME**

(30) Priority: 30.03.2012 JP 2012079114
(71) Applicant: Kyocera Corporation, Kyoto-shi Kyoto 612-8501 (JP); Kabushiki Kaisha Toyota Jidoshokki, Kariya-shi, Aichi 448-8671 (JP)
(72) Inventor: ABE, Yuichi, Kariya-shi Aichi 448-8671 (JP); NABESHIMA, Yutaka, Kyoto-shi Kyoto 612-8501 (JP); IWATA, Yoshitaka, Kariya-shi Aichi 448-8671 (JP); MORI, Shogo, Kariya-shi Aichi 448-8671 (JP); KAMIYAMA, Daizo, Kariya-shi Aichi 448-8671 (JP)
(74) Representative: Viering, Jentschura & Partner Patent- und Rechtsanwälte
(86) International application number: PCT/JP2013/059707
(87) International publication number: WO 2013/147240

(57) **Abstract**

Provided are a flow path member that suppresses flow path breakage, a heat exchanger and a semiconductor device using the same. This flow path member (1) has a flow path (5) in which a fluid flows and which is constituted by a lid portion (2), a partition wall portion (3b), a side wall portion (3) and a bottom plate portion (4). At least one of the partition wall portion and the sidewall portion is partly embedded in at least one of the lid portion (2) and the bottom plate portion (4) for direct connection. Therefore, even if a thermal stress is repeatedly developed in the flow path member (1), breakage of junctures (8) of the lid portion (2), the partition wall portion (3b), the side wall portion (3) and the bottom plate portion (4) that constitute the flow path is suppressed, and sealing performance of the flow path (5) is increased. Further, breakage of the flow path (5) can be suppressed even if a high-pressure fluid is passed through the flow path (5), breakage of the flow path due to the thermal stress can be suppressed in a heat exchanger and a semiconductor device using the flow path member (1), heat exchange efficiency can be improved, and reliability can be improved.

## Description

### Technical Field

The present invention relates to a flow path member, and a heat exchanger and a semiconductor device using the same.

### Background Art

In recent years, as hybrid cars and electric cars become prevalent rapidly, semiconductor devices, including an inverter and a so-called power module such as an AC-DC power converter have been coming into wider use.

Such a semiconductor device, which is not limited to automotive applications, generally undergoes repeated large-current switching and eventually generates heat at high temperature, and therefore, a forced cooling system is required to avoid deterioration in the performance capabilities of a semiconductor element.

In Patent Literature 1, there is disclosed a vehicle-mounted inverter apparatus which employs, as means for cooling a semiconductor element subjected to high temperature, a cooler comprising a stack of aluminum nitride layers having excellent thermal conductivity and an internally provided cooling flow path (semiconductor device using a flow path member).

### Citation List

### Patent Literature

Patent Literature 1: Japanese Unexamined Patent Publication JP-A 2007-184479

### Summary of Invention

### Technical Problem

However, in the semiconductor device as disclosed in Patent Literature 1, although a stacked body composed of a stack of aluminum nitride thin plates constitutes a flow path into which a fluid flows, the stacked body is fastened by means of screws, and therefore, the semiconductor device is, when it is installed near an engine, subjected to severe heating cycles, and, a thermal stress entailed by the heating cycles causes screw loosening in the stacked body (flow path breakage), which may impair sealing performance of the flow path.

The invention has been devised in view of the problem as mentioned supra, and accordingly an object of the invention is to provide a flow path member which is capable of suppressing flow path breakage even under the development of a thermal stress, and also a heat exchanger and a semiconductor device using the same.

### Solution to Problem

The invention provides a flow path member comprising: a lid portion; a bottom plate portion; and a partition wall portion and a sidewall portion which are disposed between the lid portion and the bottom plate portion, in which the lid portion, the partition wall portion, the sidewall portion, and the bottom plate portion constitute a flow path in which a fluid flows, and, at least one of the partition wall portion and the sidewall portion is partly embedded in at least one of the lid portion and the bottom plate portion for direct connection.

Moreover, the invention provides a heat exchanger comprising: the flow path member having the above-described structure; and a metal member placed on the lid portion of the flow path member.

Furthermore, the invention provides a semiconductor device comprising: the heat exchanger having the above-described structure; and a semiconductor element mounted on the metal member of the heat exchanger.

### Advantageous Effects of Invention

According to the flow path member pursuant to the invention, since the lid portion, the partition wall portion, the sidewall portion, and the bottom plate portion constitute a flow path in which a fluid flows, and at least one of the partition wall portion and the sidewall portion is partly embedded in at least one of the lid portion and the bottom plate portion for direct connection, even if a thermal stress is developed in the flow path member, it is possible to suppress breakage of a juncture where part of at least one of the partition wall portion and the sidewall portion stays in an embedded state for direct connection, and thereby increase sealing performance of the flow path.

Moreover, according to the heat exchanger pursuant to the invention, since the metal member is placed on the lid portion of the flow path member having the above-described structure, it is possible to effect efficient heat exchange between the lid portion and the metal member, and thereby provide the heat exchanger to operate with high heat-exchange efficiency.

Moreover, according to the semiconductor device pursuant to the invention, since the semiconductor element is placed on the metal member of the heat exchanger having the above-described structure, it is possible to provide the semiconductor device to be capable of suppressing temperature rise resulting from heat generated by the semiconductor element in a simple structure.

### Brief Description of Drawings

Other and further objects, features, and advantages of the invention will be more explicit from the following detailed description taken with reference to the drawings wherein:
FIG. 1A is a perspective view of a flow path member according to an embodiment;
FIG. 1B is a fragmentary sectional views taken along the line X-X depicted in FIG. 1A;
FIG. 1C is a fragmentary sectional views taken along the line X-X depicted in FIG. 1A;
FIG. 1D is an enlarged fragmentary sectional view showing a part C enclosed with broken lines depicted in FIG. 1B;
FIG. 1E is an enlarged fragmentary sectional view showing a part C enclosed with broken lines depicted in FIG. 1C;
FIG. 2A is an enlarged fragmentary sectional view of another example of the flow path member according to the embodiment, illustrating a part corresponding to the part C enclosed with broken lines depicted in FIG. 1B;
FIG. 2B is an enlarged fragmentary sectional view of another example of the flow path member according to the embodiment, illustrating a part corresponding to the part C enclosed with broken lines depicted in FIG. 1C;
FIG. 3A is an enlarged fragmentary sectional view of still another example of the flow path member according to the embodiment, illustrating a part corresponding to the part C enclosed with broken lines depicted in FIG. 1B;
FIG. 3B is an enlarged fragmentary sectional view of still another example of the flow path member according to the embodiment, illustrating a part corresponding to the part C enclosed with broken lines depicted in FIG. 1C;
FIG. 4A is a perspective view showing still another example of the flow path member according to the embodiment;
FIG. 4B is a plan view of still another example of the flow path member according to the embodiment, illustrating a detached part of a stacked body;
FIG. 5A is a side view of yet another example of the flow path member according to the embodiment, illustrating a state where a lid portion, a partition wall portion, a sidewall portion, and a bottom plate portion constituting the flow path member are fastened together by screws;
FIG. 5B is a side view of yet another example of the flow path member according to the embodiment, illustrating a state where the aforementioned portions are fastened together by a swaging member;
FIG. 6 is a perspective view illustrating an example of a heat exchanger according to the embodiment, having a metal member placed on the lid portion of the flow path member;
FIG. 7 is a perspective view illustrating an example of a semiconductor device according to the embodiment, having a semiconductor element mounted on the heat exchanger;
FIG. 8A is a sectional view of an example of a housing-stored semiconductor device, which is constructed by storing the semiconductor device according to the embodiment in a housing, placed on a heat-generating element, illustrating a case where the bottom plate portion of the flow path member and the housing are formed independently as separate components;
FIG. 8B is a sectional view of an example of a housing-stored semiconductor device, which is constructed by storing the semiconductor device according to the embodiment in a housing, placed on a heat-generating element, illustrating a case where the bottom plate portion of the flow path member and the housing are formed integrally with each other; and
FIG. 8C is a sectional view of an example of a housing-stored semiconductor device, which is constructed by storing the semiconductor device according to the embodiment in a housing, placed on a heat-generating element, illustrating a modified example of the flow path member in which fins are stored inside the flow path.

### Description of Embodiments

Hereinafter, embodiments of the invention will be described with reference to drawings.

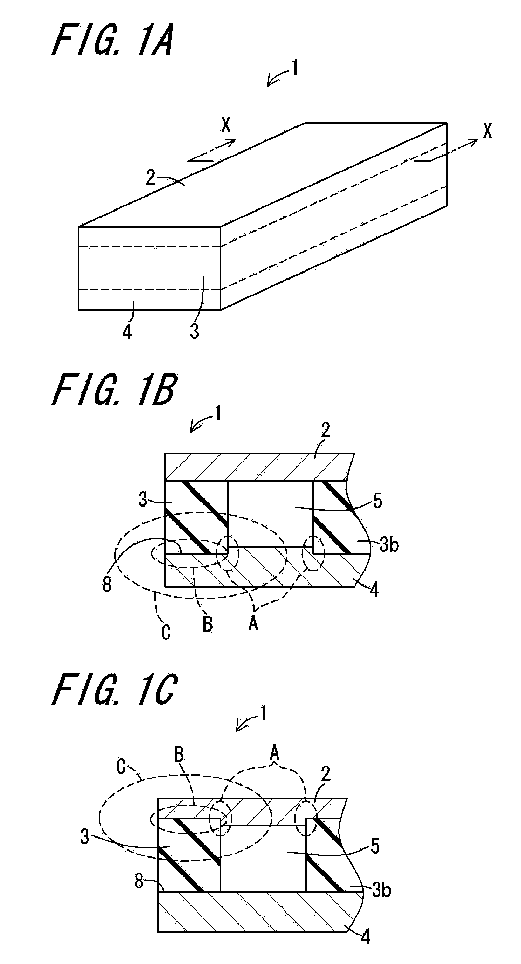

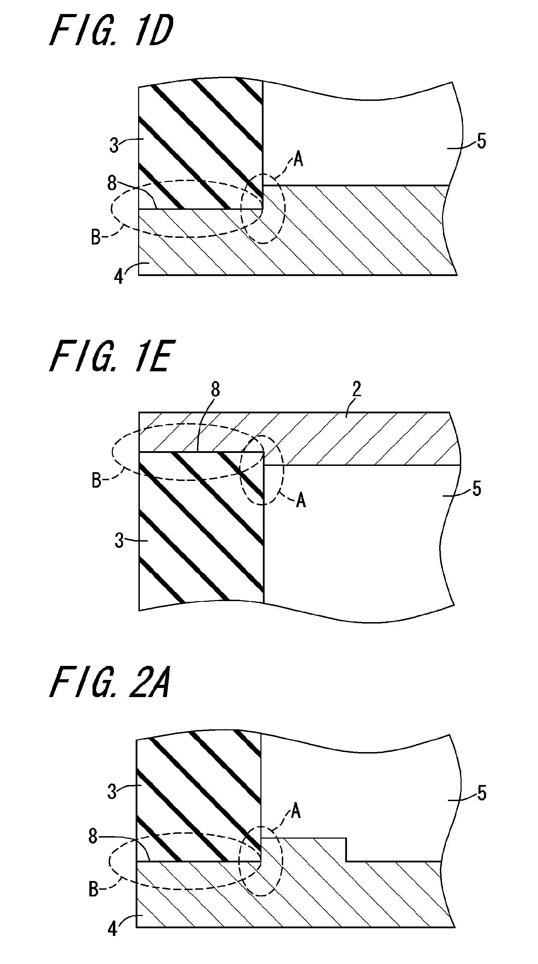

FIG. 1A is a perspective view of a flow path member according to an embodiment. FIGS. 1B and 1C are fragmentary sectional views taken along the line X-X depicted in FIG. 1A. FIG. 1D is an enlarged fragmentary sectional view showing a part C enclosed with broken lines depicted in FIG. 1B. FIG. 1E is an enlarged fragmentary sectional view showing a part C enclosed with broken lines depicted in FIG. 1C.

As shown in FIGS. 1A to 1E, a flow path member 1 according to the embodiment is composed of a lid portion 2, a bottom plate portion 4, and a partition wall portion 3b and a sidewall portion 3 which are disposed between the lid portion 2 and the bottom plate portion 4, and, in this construction, an internal space surrounded by the lid portion 2, the partition wall portion 3b, the sidewall portion 3, and the bottom plate portion 4 serves as a flow path 5 for the passage of a fluid such as a gas or liquid.

According to the flow path member 1 of the embodiment, at least one of the partition wall portion 3b and the sidewall portion 3 is partly embedded in at least one of the lid portion 2 and the bottom plate portion 4 for direct connection.

As used herein, the term "direct connection" means that at least one of the partition wall portion 3b and the sidewall portion 3 is joined directly to at least one of the lid portion 2 and the bottom plate portion 4 without the placement of, for example, an elastic body such as an O-ring or an adhesive in a juncture 8.

In the flow path member 1 as shown in FIGS. 1B and 1D, the bottom sides of, respectively, the sidewall portion 3 and the partition wall portion 3b constituting the flow path 5 are each partly embedded in the bottom plate portion 4 inwardly beyond the surface thereof constituting a flow path wall for direct connection. On the other hand, in the flow path member 1 as shown in FIGS. 1C and 1E, the top sides of, respectively, the sidewall portion 3 and the partition wall portion 3b are each partly embedded in the lid portion 2 inwardly beyond the surface thereof constituting a flow path wall for direct connection.

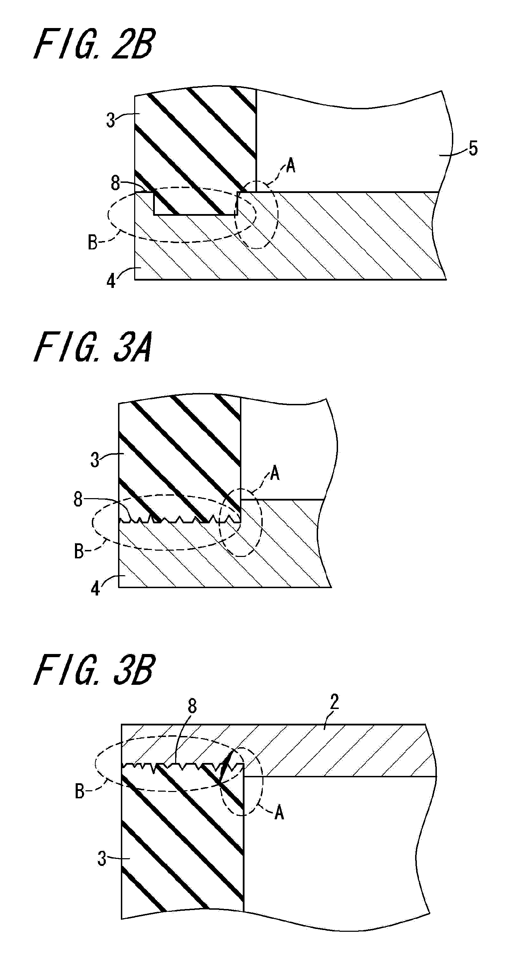

Moreover, in FIGS. 2A and 2B, there is shown another embodiment in which part of the bottom side of the sidewall portion 3 constituting the flow path 5 is embedded in the bottom plate portion 4, and more specifically, FIG. 2A shows a case where, as indicated by a part A enclosed with broken lines, the bottom plate portion 4 protrudes in part, and part of the bottom side of the sidewall portion 3 is received in a recess formed in the protruded area, and FIG. 2B shows a case where, as indicated by a part B enclosed with broken lines, a convexity is formed at one end of the sidewall portion 3 and a recess is formed at the surface of the bottom plate portion 4 so as to be opposed to the convexity, and the convexity at one end of the sidewall portion 3 is received in the recess of the bottom plate portion 4. Although not shown in the figures, the lid portion 2-facing side of the sidewall portion 3 may be shaped similarly, and also the partition wall portion 3b may be made similar in form to the sidewall portion 3.

Moreover, according to an example of a method for manufacturing the flow path member 1 of the embodiment, the first step is to prepare sintered members for forming the partition wall portion 3b and the sidewall portion 3. Next, the lid portion 2 and the bottom plate portion 4 are obtained by molding a powder material which is lower in melting point than the partition wall portion 3b and the sidewall portion 3 into a predetermined shape, or by molding a molten material having a low melting point into a predetermined shape by means of injection molding or otherwise. Subsequently, the partition wall portion 3b and the sidewall portion 3 which are previously prepared are combined together so as to be sandwiched between the lid portion 2 and the bottom plate portion 4, and are then fired at a predetermined temperature under pressure, whereby the flow path member 1 can be obtained in which the lid portion 2 and the bottom plate portion 4 are each joined directly to the partition wall portion 3b and the sidewall portion 3. In this case, since the lid portion 2 and the bottom plate portion 4 are made of a material which is lower in melting point than the previously prepared partition wall portion 3b and sidewall portion 3, by performing firing process at a temperature higher than the melting point of the partition wall portion 3b and the sidewall portion 3, the partition wall portion 3b and the sidewall portion 3 are each partly embedded in the lid portion 2 and the bottom plate portion 4 for direct connection. Although the above description deals with the case where both of the partition wall portion 3b and the sidewall portion 3 are partly embedded in both of the lid portion 2 and the bottom plate portion 4, it is sufficient that at least one of the partition wall portion 3b and the sidewall portion 3 be partly embedded in at least one of the lid portion 2 and the bottom plate portion 4, wherefore some adjustment may be made to the manufacturing method. Unless otherwise noted, the following description deals with the case where both of the partition wall portion 3b and the sidewall portion 3 are partly embedded in both of the lid portion 2 and the bottom plate portion 4.

It is noted that, when ceramics is used as a material having a relatively high melting point for forming the partition wall portion 3b and the sidewall portion 3, a metal such as copper or aluminum or a resin can be used as a material having a relatively low melting point for forming the lid portion 2 and the bottom plate portion 4, and, on the other hand, when a metal is used as a material having a relatively high melting point for forming the partition wall portion 3b and the sidewall portion 3, a resin can be used as a material having a relatively low melting point for forming the lid portion 2 and the bottom plate portion 4.

Thus, in the flow path member 1 according to the embodiment, at least one of the partition wall portion 3b and the sidewall portion 3 is partly embedded in at least one of the lid portion 2 and the bottom plate portion 4 for direct connection. In this construction, even if a thermal stress developed under high-temperature conditions is applied to the flow path member 1 from the inside and outside thereof, it is possible to suppress breakage of the juncture 8 where part of at least one of the partition wall portion 3b and the sidewall portion 3 stays in an embedded state for direct connection, as well as to suppress appearance of a gap opened toward the flow path 5 in the juncture 8. Accordingly, the sealing performance of the flow path 5 can be increased, and also the pressure acting on a fluid flowing in the flow path 5 can be raised, with a consequent enhancement in cooling capability.

FIGS. 3A and 3B show still another example of the flow path member according to the embodiment, and more specifically FIG. 3A is an enlarged fragmentary sectional view illustrating a part corresponding to the part C enclosed with broken lines depicted in FIG. 1B, and FIG. 3B is an enlarged fragmentary sectional view illustrating a part corresponding to the part C enclosed with broken lines depicted in FIG. 1C.

As shown in FIGS. 3A and 3B, it is preferable that a plurality of recesses are formed at one end of the sidewall portion 3 (recesses of the sidewall portion 3) and at least one of the lid portion 2 and the bottom plate portion 4 has a plurality of convexities corresponding to the recesses, and that the recess fits the convexity for mutual connection. Likewise, in the partition wall portion 3b, although it is not illustrated in FIGS. 3A and 3B, recesses may be formed at one end thereof, and, also in this case, the recess fits the convexity of at least one of the lid portion 2 and the bottom plate portion 4 for mutual connection.

That is, in the connection between the lid portion 2 and at least one of the partition wall portion 3b and the sidewall portion 3 and the connection between the bottom plate portion 4 and at least one of the partition wall portion 3b and the sidewall portion 3, at least one of the partition wall portion 3b and the sidewall portion 3 is partly embedded in at least one of the lid portion 2 and the bottom plate portion 4 for direct connection, and also, in each juncture 8, the partition wall portion 3b and the sidewall portion 3 are formed with a plurality of recesses, and the lid portion 2 and the bottom plate portion 4 are formed with a plurality of convexities corresponding to the recesses, the recesses of the partition wall portion 3b and the sidewall portion 3 fitting their respective convexities of the lid portion 2 and the bottom plate portion 4 for mutual connection. This makes it possible to achieve a strong anchor effect in the juncture 8, and thereby suppress breakage of the juncture 8 which is most susceptible to a thermal stress. Accordingly, the sealing performance of the flow path 5 can be increased, and also the pressure acting on a fluid flowing in the flow path 5 can be raised, with a consequent enhancement in cooling capability.

The size of the recess formed in the partition wall portion 3b and the sidewall portion 3 is, for example, when the partition wall portion 3b and the sidewall portion 3 have a width dimension of 1 to 20 mm, preferably set to be one-hundred thousandth to one-millionth part of the width dimensions of the partition wall portion 3b the sidewall portion 3 in terms of circle diameter-equivalent dimension, and, the depth of the recess is preferably set to fall in a range of 0.1 to 10 µm. By forming a plurality of such recesses all over the joining surfaces of the partition wall portion 3b the sidewall portion 3, it is possible to disperse a stress over the entire joining surface and thereby increase the joining strength. It is advisable to set the size of the convexity in conformity to the size of the recess.

Moreover, it is preferable that the junctures 8 at the lid portion 2 and the bottom plate portion 4 are free from an altered layer, and therefore this makes it possible to ensure the original strength of each constituent component and suppress a decrease in the joining strength. The altered layer refers to, for example, when a resin is used for each constituent component, a layer which is changed in its nature due to fusion of the resin under heat and eventually suffers from deterioration in joining strength characteristics. However, in a case where ceramics is used as part of the materials for forming the flow path member, and improvement in thermal conductivity can be achieved by removing glass components in the surface layer through application of heat irradiation to promote heat dissipation properties, the term "modified layer" will be adopted rather than "altered layer".

Moreover, in the flow path member 1 according to the embodiment, out of the lid portion 2 and the bottom plate portion 4, the one in which part of at least one of the partition wall portion 3b and the sidewall portion 3 is embedded for direct connection is preferably made of a flexible material. In this construction, when an electronic component such as a semiconductor element is mounted on a highly rigid ceramic substrate or the like additionally disposed above the lid portion 2 or below the bottom plate portion 4, it is possible to avoid the problem of accidental separation between the electronic component and the flow path member 1 resulting from the difference in thermal expansion between them, as well as to suppress occurrence of significant warpage of the lid portion 2 or the bottom plate portion 4 in response to the placement of the electronic component. Accordingly, the burdens on each of the juncture 8 of the lid portion 2 with the sidewall portion 3 and the partition wall portion 3b and the juncture 8 of the bottom plate portion 4 with the sidewall portion 3 and the partition wall portion 3b can be reduced.

Materials that exemplify the flexible material used for the lid portion 2 and the bottom plate portion 4 are resin and metal. In this case, a non-flexible material can be used for the partition wall portion 3b and the sidewall portion 3. Specifically, when the lid portion 2 and the bottom plate portion 4 are made of a resin material, highly rigid ceramics, resin composite ceramics, or a metal material can be used as the material for forming the partition wall portion 3b and the sidewall portion 3. On the other hand, when the lid portion 2 and the bottom plate portion 4 are made of a metal material, a metal material such as copper or aluminum or ceramics may be used as the material for forming the partition wall portion 3b and the sidewall portion 3. Moreover, the lid portion 2 and the bottom plate portion 4 may be made of metal foil, and, in this case, although copper, aluminum, or an alloy of these metals can be used, stainless steel or titanium is more desirable for use because of its high chemical resistance.

It is particularly desirable to use a resin material as the flexible material used for the lid portion 2 and the bottom plate portion 4. By so doing, when the partition wall portion 3b and the sidewall portion 3 are made of ceramics or a metal material, and the lid portion 2, the partition wall portion 3b, the sidewall portion 3, and the bottom plate portion 4 are joined together under pressure, since the partition wall portion 3b and the sidewall portion 3 are partly embedded in the lid portion 2 and the bottom plate portion 4 made of the flexible resin material, it follows that the partition wall portion 3b and the sidewall portion 3 are partly covered with the lid portion 2 and the bottom plate portion 4. This makes it possible to suppress occurrence of a gap in the juncture 8 even if a thermal stress is developed repeatedly in the flow path member 1, and thereby render the flow path 5 resistant to breakage even if a high-pressure fluid is passed through the flow path 5, wherefore the flow path member 1 features high sealability.

Examples of resin materials that can be used for the lid portion 2 and the bottom plate portion 4 include POM (polyoxymethylene), ABS (acrylonitrile butadiene styrene), PA (nylon 66), PP (polypropylene), PE (polyethylene), PMMA (polymethylmethacrylate), PET (polyethylene terephthalate), PEI (polyetherimide-based resin), PBT (polybutylene terephthalate-based resin), PA (polyamide-based resin), PAI (polyamide-imide-based resin), PPS (polyphenylene sulphide-based resin), polyphenylene ether-based resin, PEEK (polyether ether ketone), a mixed resin of polyphenylene ether-based resin, styrenic resin, and polyamide-based resin, PTFE (polytetrafluoroethylene fluororesin), and PC (polycarbonate resin). Among them, PPS, PEI, PAI, PTFE, and PEEK are particularly desirable because of their excellent heat resistance and chemical resistance.

Moreover, as the ceramic material for forming the partition wall portion 3b and the sidewall portion 3, alumina, silicon nitride, aluminum nitride, silicon carbide, zirconia, and a composite of these materials can be used, and, although all the aforementioned materials are excellent in heat resistance and chemical resistance, when priority is given to thermal conductivity, silicon carbide, aluminum nitride, and silicon nitride are desirable for use, and on the other hand, when it is desired to produce an inexpensive flow path member 1 of high strength, alumina or silicon carbide is desirable for use.

Moreover, when a heat-generating element is mounted on the upper surface of the lid portion 2 or the lower surface of the bottom plate portion 4 in the flow path member 1 according to the embodiment, it is preferable that the resin material for forming the lid portion 2 and the bottom plate portion 4 is a highly heat-conductive resin. In this case, heat generated in the heat-generating element can be efficiently transmitted to a fluid flowing through the interior of the flow path member 1, wherefore even higher heat-exchange efficiency can be achieved in the flow path member 1.

Exemplary of the highly heat-conductive resin material is a resin added with highly heat-conductive fillers in which the thermal conductivity falls in a range of 15 to 30 W/m·k. In a case where the lid portion 2 and the bottom plate portion 4 are required to have insulation properties, it is advisable to use fillers composed predominantly of alumina, aluminum nitride, boron nitride, or the like, and, on the other hand, when insulation properties are unnecessary, it is advisable to adopt a metal such as tin, aluminum, magnesium, silver, manganese, or copper for use as fillers.

Moreover, when the flow path member 1, in which a highly heat-conductive resin material is used for the lid portion 2 or the bottom plate portion 4 thereof, is incorporated in a heat exchanger or a semiconductor device, and the assembly is installed in a hot environment, it is desirable to store it in a housing made of a resin material having low thermal conductivity or the like in order to suppress that the lid portion 2 or the bottom plate portion 4 of the flow path member 1 will take up ambient heat.

Moreover, in the flow path member 1 according to the embodiment, it is preferable that the partition wall portion 3b and the sidewall portion 3 are higher in hardness than the lid portion 2 and the bottom plate portion 4. In this case, when the lid portion 2, the partition wall portion 3b, the sidewall portion 3, and the bottom plate portion 4 are joined together by means of screws or otherwise, since the partition wall portion 3b and the sidewall portion 3 are embedded in the lid portion 2 and the bottom plate portion 4 having lower hardness, it follows that the partition wall portion 3b and the sidewall portion 3 constituting the flow path 5 are partly covered with the bottom plate portion 4. This makes it possible to suppress occurrence of a gap in each of the juncture 8 of the lid portion 2 with the partition wall portion 3b and the sidewall portion 3 and the juncture 8 of the bottom plate portion 4 with the partition wall portion 3b and the sidewall portion 3 even if a thermal stress is developed repeatedly in the flow path member 1, and thereby suppress breakage of the flow path 5 even with the passage of a high-pressure fluid therethrough.

For example, when the partition wall portion 3b and the sidewall portion 3 are made of ceramics having an alumina content of 96% by mass and the bottom plate portion 4 is made of polycarbonate resin, even if the partition wall portion 3b, the sidewall portion 3, the lid portion 2, and the bottom plate portion 4 are made flat, it is sufficient to set a pressurizing force required for the connection at about 1 MPa, and consequently, in the lid portion 2 and the bottom plate portion 4, a recess of about 5 to 10 µm is obtained at the juncture 8. The larger the degree of the recess is, the higher the effect of suppressing breakage of the juncture 8 resulting from fluid pressure is, but, even if the degree of the recess is small, in contrast to a case where no recess is provided, the probability of occurrence of flow path breakage can be markedly lowered. This is probably because, in the absence of a recess, when a thermal stress is repeatedly applied to the flow path member 1, a slight gap appears in between the lid portion 2 and at least one of the partition wall portion 3b and the sidewall portion 3, and between the bottom plate portion 4 and at least one of the partition wall portion 3b and the sidewall portion 3, and consequently, when a high-pressure fluid is passed through the flow path 5, inconveniently, the gap exerts the influence of a notch on the flow path member 1, which easily leads to occurrence of breakage in the flow path member 1. Accordingly, in the presence of a recess, no matter how small it is, the onset of a gap can be suppressed, wherefore, in the flow path member 1, the probability of occurrence of flow path breakage can be lowered.

A description will be given below as to an example of a method for joining the lid portion 2 and the bottom plate portion 4, which are flexible members, to the partition wall portion 3b and the sidewall portion 3.

In a case where the partition wall portion 3b and the sidewall portion 3 are made of aluminum or an aluminum alloy used as a non-flexible material, that part of each of the partition wall portion 3b and the sidewall portion 3 which will serve as the juncture 8 is immersed in a basic aqueous solution such as a sodium hydroxide solution in advance as pretreatment process, and is whereafter subjected to electrochemical etching process to form a plurality of minute recesses.

On the other hand, in the case of using ceramics as the non-flexible material, it is advisable to adopt, for example, a method of uniformly dispersing spherical resin particles which are based on a heretofore known porous-body manufacturing method, in a ceramic slurry, and more specifically, a plurality of recesses can be formed at the juncture 8-forming part by applying a coat of a slurry made of porous ceramic partly on a member formed of a densified ceramic slurry, and then firing the coated member at a predetermined temperature. Moreover, when a plurality of recesses are formed at part of each of the sidewall portion 3 and the partition wall portion 3b which will serve as the juncture 8 after the production of sintered bodies for forming the sidewall portion 3 and the partition wall portion 3b, so long as the non-flexible material is alumina, glass components such as silica can be removed by immersing only the juncture 8-forming part in a hydrofluoric acid solution, thereby creating recess-forming clearances between alumina particles only in the surface layer responsible for connection. In another alternative, recesses can be formed through the removal of glass components such as silica by surface irradiation of laser light.

Thus, in the case of removing glass components present in the ceramic surface, in the flow path member 1, the thermal resistance at the juncture of the surface with the opposed metal or resin material can be reduced, wherefore this glass component-removed part can be deemed to be the modified layer rather than the altered layer.

Then, the members constituting the partition wall portion 3b and the sidewall portion 3 are placed inside a mold, and the resin or metal material in a molten state for forming the lid portion 2 and the bottom plate portion 4 is subjected to injection molding. In this way, part of at least one of the lid portion 2 and the bottom plate portion 4 finds its way into the recess of at least one of the partition wall portion 3b and the sidewall portion 3 so as to become a convexity, and in consequence, the recess of at least one of the partition wall portion 3b and the sidewall portion 3 fits the convexity of at least one of the lid portion 2 and the bottom plate portion 4, whereby the partition wall portion 3b or the sidewall portion 3 joined to the lid portion 2 or the bottom plate portion 4 can be obtained.

The juncture 8 of the flexible member with the non-flexible member thusly obtained takes on a double joining configuration; that is, at least one of the partition wall portion 3b and the sidewall portion 3 that are non-flexible members is partly embedded in at least one of the lid portion 2 and the bottom plate portion 4 that are flexible members for direct connection, and, in each juncture 8, part of at least one of the partition wall portion 3b and the sidewall portion 3 that are each formed with a plurality of recesses fits the convexities of at least one of the lid portion 2 and the bottom plate portion 4 for mutual connection. Moreover, since the lid portion 2 and the bottom plate portion 4 are free from an altered layer which causes a decrease in joining strength, even when passing a fluid while raising the pressure acting thereon to increase the heat-exchange efficiency, it is possible to achieve a strong anchor effect in the juncture 8, and thereby suppress breakage of the juncture 8 under a thermal stress.

In the case of mounting a heat-generating element above the lid portion 2 or below the bottom plate portion 4, when these portions are made of resin, it is preferable that the resin is a highly heat-conductive resin for the transmission of heat to the flow path member 1. The following description deals with an example of a manufacturing method therefor.

As has already been described, the members constituting the sidewall portion 3 and the partition wall portion 3b are placed inside a mold, and a molten resin which sets into the highly heat-conductive resin is injection-molded in an area constituting the juncture 8 of the lid portion 2 with the bottom plate portion 4, and more specifically, powder of an alloy of low-melting-point metals such as tin and magnesium or manganese, silver, copper, aluminum, or the like for forming each member is added to a resin such as PPS, PTFE, or PAI which has a heat resistance of higher than or equal to at least 200°C and a melting point of higher than or equal to 230°C, and then injection molding is performed thereon at a temperature higher than or equal to the melting points of the materials, whereby the flow path member 1 can be obtained in which the highly heat-conductive resin-made lid portion 2 and bottom plate portion 4 are joined to the partition wall portion 3b and the sidewall portion 3.

In the case of exercising thermal conductivity control on the basis of the amount of metal powder to be added to the molten resin, the flow of the resin becomes sluggish due to the addition of the metal powder, which results in poor moldability. Thus, with the aim of attaining high thermal conductivity with fewer amount of metal powder, by increasing the aspect ratio of the metal powder, or by adjusting the temperature for injection molding to a level in the neighborhood of the melting point of the metal powder, it is possible to orient the longitudinal axis of the metal filler, and thereby form a heat transmission path between the metal fillers even if the amount of the metal powder to be added is small, wherefore the highly heat-conductive resin can be obtained. Particularly, depending on mold configuration and gate location design, the direction of the longitudinal axis of the metal filler can be made substantially perpendicular to the juncture 8.

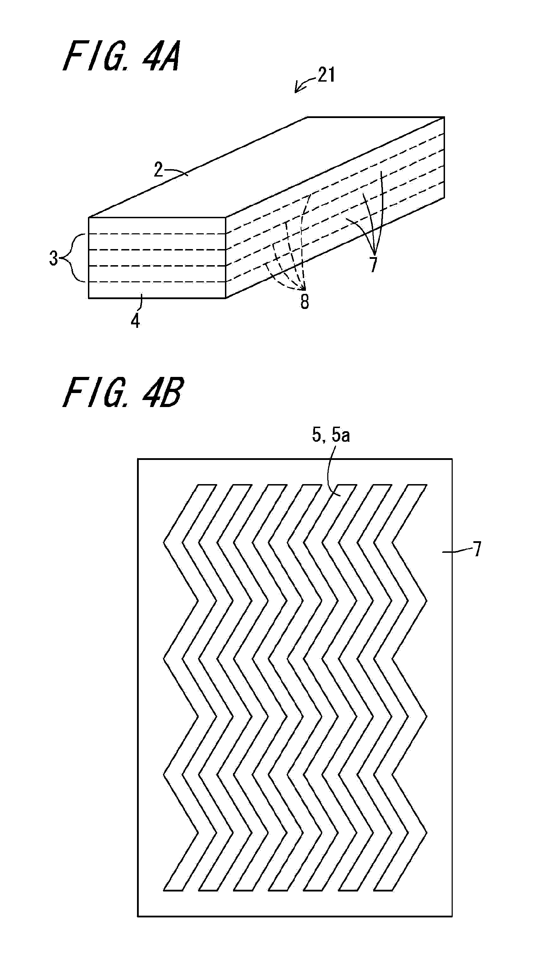

FIG. 4A is a perspective view illustrating still another example of the flow path member according to the embodiment, and FIG. 4B is a plan view illustrating a detached part of a stacked body constituting the flow path member.

As shown in FIGS. 4A and 4B, in a flow path member 21 according to an embodiment, at least one of the partition wall portion 3b and the sidewall portion 3 comprises a stacked body composed of a stack of a plurality of plate-like bodies 7 made of ceramic layers (the stacked body is, as exemplified, composed of three plate-like bodies 7).

By constituting at least one of the partition wall portion 3b and the sidewall portion 3 in such a layered form, it is possible to facilitate formation of an elaborate flow path 5, as well as to render the flow path member 21 excellent in all of heat resistance, chemical resistance, and pressure resistance.

For example, the flow path 5 is, when it is given a simple form, readily fabricated by means of extrusion molding or otherwise, but, on the other hand, when the flow path 5 has a complex form such as a wavy form as seen in a plan view, it may be difficult to achieve the working of the flow path into such a form by the extrusion molding technique, and also, when a flow path-to-flow path 5 width is narrow, it may be difficult to secure heat resistance, chemical resistance, and pressure resistance. Accordingly, in the case of providing the flow path 5 having such a form, it is advisable to produce the partition wall portion 3b and the sidewall portion 3 in the form of a stacked body composed of a stack of ceramic layer-made plate-like bodies 7 by creating a through hole 5a which will serve as the desired flow path 5 in a flat plate made of an unfired ceramic green sheet, stacking such flat plates, and firing the stacked plates.

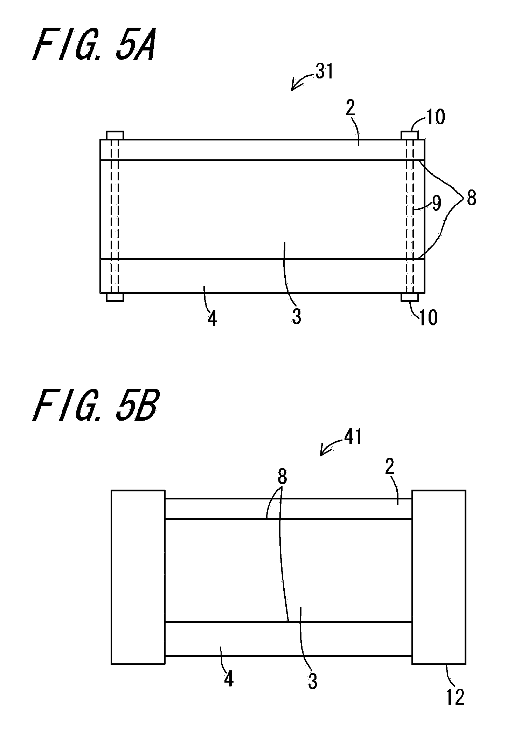

FIG. 5A is a side view of yet another example of the flow path member according to the embodiment, illustrating a state where a lid portion, a partition wall portion, a sidewall portion, and a bottom plate portion constituting the flow path member are fastened together by screws, and FIG. 5B is a side view illustrating a state where the aforementioned portions are fastened together by a swaging member.

In a flow path member 31 as shown in FIG. 5A, a screw hole 9 is provided in the lid portion 2, the partition wall portion 3b, the sidewall portion 3, and the bottom plate portion 4, so that the lid portion 2, the partition wall portion 3b, the sidewall portion 3, and the bottom plate portion 4 in a stacked state can be threadedly joined to each other by a screw 10. In a flow path member 41 as shown in FIG. 5B, the lid portion 2, the partition wall portion 3b, the sidewall portion 3, and the bottom plate portion 4 are joined together at their both lengthwise ends by a swaging member 12.

Although the above description deals with the case where the partition wall portion 3b and the sidewall portion 3 are obtained by firing a stack of ceramic green sheets so as to form a one-piece structure of ceramic layer-made plate-like bodies 7, alternatively, ceramic layer-made plate-like bodies 7 which are obtained by firing the ceramic green sheets on an individual basis may be stacked, and the stacked body may be held between the lid portion 2 and the bottom plate portion 4, and they may be fixedly joined together by means of screws, swaging members, or otherwise.

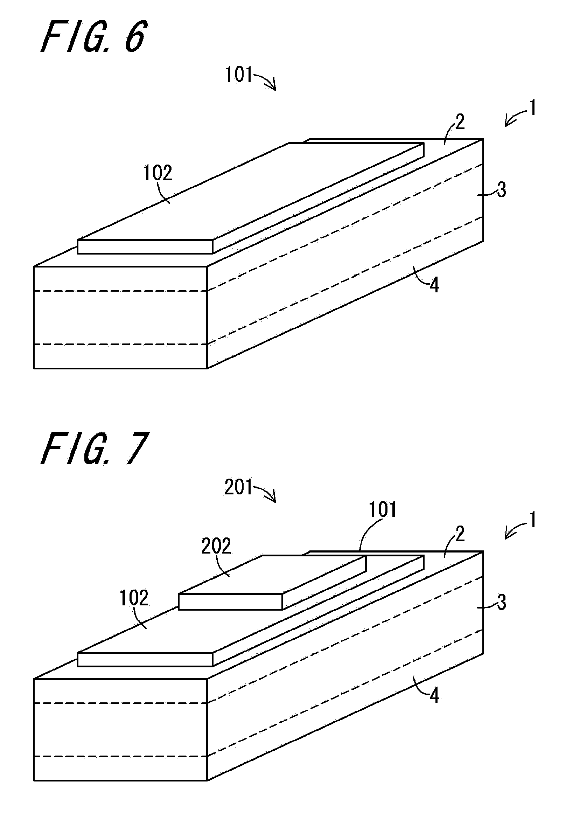

Next, a heat exchanger according to an embodiment will be described with reference to FIG. 6. FIG. 6 is a perspective view illustrating an example of a heat exchanger according to the embodiment, having a metal member placed on the lid portion of the flow path member.

In a heat exchanger 101 according to the embodiment, a metal member 102 is placed on the lid portion 2 of the flow path member 1 according to the embodiment. In this construction, the bottom plate portion 4 is made of a flexible material. Since the metal member is placed on the lid portion 2, it is possible to effect efficient heat exchange between the lid portion 2 and the metal member 102, and thereby constitute the heat exchanger to operate with high heat-exchange efficiency. Moreover, since the bottom plate portion 4 is made of a flexible material, even if a thermal stress is developed repeatedly in the heat exchanger 101, it is possible to suppress breakage of the flow path by virtue of absorption and consequent reduction of the thermal stress achieved by the bottom plate portion 4, and thereby increase the reliability of the heat exchanger 101. Note that, when the lid portion 2 is also made of a flexible material, a higher effect of thermal-stress absorption and reduction can be attained.

Next, a semiconductor device according to an embodiment will be described with reference to FIG. 7. FIG. 7 is a perspective view illustrating an example of a semiconductor device according to the embodiment, having a semiconductor element mounted on the heat exchanger.

In a semiconductor device 201 according to the embodiment, a semiconductor element 202 is mounted on the heat exchanger 101 according to the embodiment. In this construction, even if a thermal stress is developed due to repeated application of heat generated from the semiconductor device 201 in itself or heat emanating from a fluid or external environment, by virtue of the use of the heat exchanger 101 capable of absorption and reduction of the thermal stress, breakage of the flow path 5 can be suppressed, and high heat-exchange efficiency can be achieved between a fluid flowing through the flow path 5 and the semiconductor element 202 via the heat exchanger 101, wherefore the temperature of the semiconductor element 202 can be lowered efficiently.

Next, modified examples of the flow path member, the heat exchanger, and the semiconductor device according to the embodiments will be described.

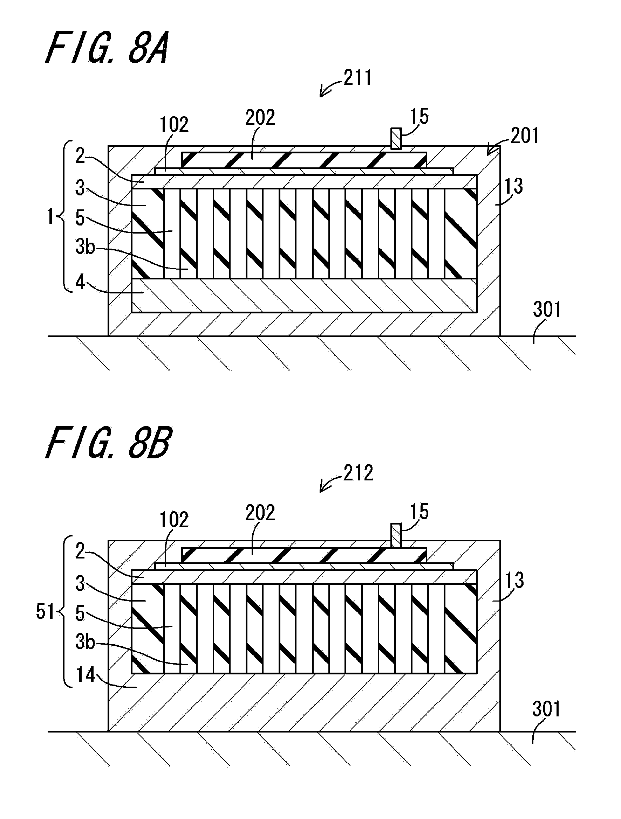

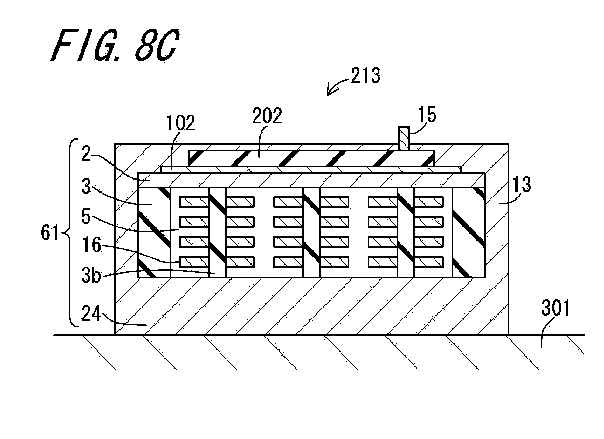

FIG. 8A is a sectional view of an example of a housing-stored semiconductor device, which is constructed by storing the semiconductor device according to the embodiment in a housing, placed on a heat-generating element, illustrating a case where the bottom plate portion of the flow path member and the housing are formed independently as separate components; FIG. 8B is a sectional view illustrating a case where the bottom plate portion of the flow path member and the housing are formed integrally with each other; and FIG. 8C is a sectional view illustrating a modified example of the flow path member in which fins are stored inside the flow path.

In FIG. 8A, there is shown a housing-stored semiconductor device 211 according to the embodiment, in which the semiconductor device 201 employing the flow path member 1 according to the embodiment thus far described is stored in a housing 13 so as to be covered therewith, and, the housing-stored semiconductor device 211 is disposed on a heat-generating element 301.

In such a housing-stored semiconductor device 211, it is preferable that the bottom plate portion 4 of the flow path member 1 is lower in thermal conductivity than the sidewall portion 3, and that the entire semiconductor device 201 including the flow path member 1, except for a signal terminal 15 connected to the semiconductor element 202 and a fluid supply tube and a fluid discharge tube (not represented graphically), or, at least the bottom plate portion 4 and part of the sidewall portion 3 of the flow path member 1, is covered with the housing 13 made of a material having a thermal conductivity as low as the thermal conductivity of the bottom plate portion 4. Use can be made of the above-described resin material or the like used for the bottom plate portion 4 for forming the housing 13.

In the housing-stored semiconductor device 211 thusly constructed, when it is disposed on the heat-generating element 301, it is possible to suppress taking-up of heat from the heat-generating element 301 by the housing 13 and the bottom plate portion 4 as well as the sidewall portion 3 of the flow path member 1. This makes it possible to suppress the influence of ambient heat on a fluid flowing through the flow path member 1, and thereby constitute the housing-stored semiconductor device 211 to operate with high heat-exchange efficiency.

In FIG. 8B, there is shown a housing-stored semiconductor device 212 according to an embodiment having a modified example of the above-described flow path member 1 according to the embodiment, or equivalently a flow path member 51 in which a bottom plate portion 14 of the housing 13 serves also as a bottom plate portion of the flow path member 51, and, the housing-stored semiconductor device 212 according to the embodiment is disposed on the heat-generating element 301.

In the housing-stored semiconductor device 212 according to the embodiment, it is preferable that the bottom plate portion 14 of the housing 13 that serves also as the bottom plate portion of the flow path member 51 is lower in thermal conductivity than the sidewall portion 3, and, when the thusly constructed housing-stored semiconductor device 212 is disposed on the heat-generating element 301, it is possible to suppress taking-up of heat from the heat-generating element 301 by the bottom plate portion 14 of the housing 13 that serves also as the bottom plate portion of the flow path member 51 and the sidewall portion 3. This makes it possible to suppress the influence of ambient heat on a fluid flowing through the flow path member 51, and thereby constitute the housing-stored semiconductor device 212 to operate with high heat-exchange efficiency.

In FIG. 8C, there is shown a housing-stored semiconductor device 213 according to an embodiment having another modified example of the above-described flow path member 1 according to the embodiment, or equivalently a flow path member 61 in which a bottom plate portion 24 of the housing 13 serves also as a bottom plate portion of the flow path member 61, and also a plurality of plate-like fins 16 are joined to the surface of the partition wall portion 3b so as to protrude inside the flow path 5, and, the housing-stored semiconductor device 213 according to the embodiment is disposed on the heat-generating element 301.

In this construction, it is preferable that the fins 16 are of a plurality of columnar or plate-like fins having circular cross-sectional profiles including an oblong (oval) profile, or quadrilateral cross-sectional profiles including a rectangular profile and a rhombus profile, that the fin 16 is formed of a plate of a highly heat-conductive metal such as aluminum or copper, or a plate of ceramics such as aluminum nitride, silicon carbide, or silicon nitride, and that the fin 16 is connected to the lid portion 2 for heat transfer through a highly heat-conductive metal or the like.

In the housing-stored semiconductor device 213 according to the embodiment, it is preferable that the bottom plate portion 24 of the housing 13 that serves also as the bottom plate portion of the flow path member 61 is lower in thermal conductivity than the sidewall portion 3, and, when the thusly constructed housing-stored semiconductor device 213 is disposed on the heat-generating element 301, it is possible to suppress taking-up of heat from the heat-generating element 301 by the bottom plate portion 24 of the housing 13 that serves also as the bottom plate portion of the flow path member 61 and the sidewall portion 3. This makes it possible to suppress the influence of ambient heat on a fluid flowing through the flow path member 61, and thereby constitute the housing-stored semiconductor device 213 to operate with high heat-exchange efficiency in.

Moreover, the fin 16 may be joined to the surface of the bottom plate portion 4, 14, 24 of the housing-stored semiconductor device 211, 212, 213 thus far described. Particularly, when the fin 16 is made of a non-flexible material, also in a juncture of the fin 16 with the bottom plate portion 4, 14, 24, the bottom plate portion 4, 14, 24 is kept in contact with the surface of the to-be-bonded end of the fin 16, wherefore the strength of connection in the juncture of the bottom plate portion 4, 14, 24 with the fin 16 can be increased, thereby attaining the sturdy flow path member 1, 51, 61.

Moreover, in the heat exchanger 101, the semiconductor device 201, and the housing-stored semiconductor device 211, 212, 213 as shown in FIGS. 7, 8A, 8B, and 8C, the metal member 102 is placed directly on the upper surface of the lid portion 2, but, when the lid portion 2 is made of a material having low insulation properties, it is advisable to interpose a member having high insulation properties, for example, a ceramic thin plate, an aluminum thin plate obtained by performing electrolytic treatment on aluminum to produce an alumina oxide film on its surface, a metal member coated with a resin which is highly resistant to heat such as polyimide, or a glass-coated metal member, between the lid portion 2 and the metal member 102.

It should be understood that the invention may be carried into effect in various forms without departing from the spirit and major features of the invention. Accordingly, the embodiments as set forth hereinabove are considered in all respects as illustrative only, and the scope of the invention is indicated by the appended claims but is not to be restricted by this specification. Moreover, all changes and modifications that come within the range of the claims are intended to be embraced in the scope of the invention.

### Reference Signs List

1, 21, 31, 41, 51, 61: Flow path member
2: Lid portion
2a: Inner surface
3: Sidewall portion
3b: Partition wall portion
4, 14, 24: Bottom plate portion
5: Flow path
5a: Through hole
7: Plate-like body
8: Juncture
9: Screw hole
10: Screw
12: Swaging member
13: Housing
16: Fin
101: Heat exchanger
102: Metal member
201: Semiconductor device
202: Semiconductor element
211, 212, 213: Housing-stored semiconductor device
301: Heat-generating element

## Claims

1. A flow path member, comprising:
a lid portion;
a bottom plate portion; and
a partition wall portion and a sidewall portion which are disposed between the lid portion and the bottom plate portion,
the lid portion, the partition wall portion, the sidewall portion, and the bottom plate portion constituting a flow path in which a fluid flows,
at least one of the partition wall portion and the sidewall portion being partly embedded in at least one of the lid portion and the bottom plate portion for direct connection.

2. The flow path member according to claim 1,
wherein, out of the lid portion and the bottom plate portion, the one in which part of at least one of the partition wall portion and the sidewall portion is embedded for direct connection is made of a flexible material.

3. The flow path member according to claim 2,
wherein the flexible material is a resin material.

4. The flow path member according to claim 3,
wherein the resin material is a highly heat-conductive resin.

5. The flow path member according to any one of claims 1 to 4,
wherein at least one of the sidewall portion and the partition wall portion is composed of a ceramic stacked body.

6. A heat exchanger, comprising:
the flow path member according to any one of claims 1 to 5; and
a metal member placed on the lid portion of the flow path member.

7. A semiconductor device, comprising:
the heat exchanger according to claim 6; and
a semiconductor element mounted on the metal member of the heat exchanger.
